# EUROPÄISCHE PATENTSCHRIFT

(11) **EP 1 072 182 B1**
(45) Veröffentlichungstag und Bekanntmachung des Hinweises auf die Patenterteilung: **19.02.2003**
(21) Anmeldenummer: 99924676.2
(22) Anmeldetag: 25.03.1999
(51) Int. Cl.: H05K 13/04

(54) **ZUFÜHRMODUL FÜR ELEKTRISCHE BAUELEMENTE ZU EINEM BESTÜCKAUTOMATEN**
SUPPLY MODULE FOR FEEDING ELECTRICAL COMPONENTS TO AN AUTOMATIC PLACEMENT DEVICE
MODULE D'ACHEMINEMENT DE COMPOSANTS ELECTRIQUES VERS UN DISPOSITIF AUTOMATIQUE DE MISE EN PLACE

(30) Priorität: 26.03.1998 DE 19813500
(43) Veröffentlichungstag der Anmeldung: 31.01.2001
(73) Patentinhaber: SIEMENS AKTIENGESELLSCHAFT, 80333 München (DE)
(72) Erfinder: MELF, Johann, D-82541 Münsing (DE); LIEBEKE, Thomas, D-81479 München (DE)
(86) Internationale Anmeldenummer: DE9900896
(87) Internationale Veröffentlichungsnummer: WO99049714

(56) Entgegenhaltungen:
- EP-A- 0 460 834

## Beschreibung

Die Erfindung bezieht sich auf ein Zuführmodul für elektrische Bauelemente zu einem Bestückautomaten.

Ein derartiges Modul ist z.B. durch die EP 0 460 834 A1 bekannt geworden. Danach sind die Bauelemente in einem Trägerband gespeichert, daß schrittweise durch das Modul hindurchgezogen wird. Dabei werden die Bauelemente unter einem in der Vorschubrichtung bewegbaren Schieber bis zu einer Abholposition transportiert. Um beim ruckartigen Vorschieben des Bandes ein Herausspringen der Bauelemente zu vermeiden, überdeckt der Schieber zunächst die Abholposition, die er beim Annähern eines Entnahmewerkzeuges des Bestückautomaten freigibt, so daß das Bauelement z.B. mittels einer Saugpipette entnommen werden kann. Der Schieber wird mittels einer Hebelmechanik betätigt, die mit einem Antrieb für das Bauteileband gekoppelt ist, wobei der Schieberhub gleich der Teilung des Bauteilebandes ist.

Derartige Zuführmodule werden möglichst schmal gehalten, um eine möglichst große Anzahl im Zugriffbereich des Bestückwerkzeuges anordnen zu können. In Bauteilebändern gleicher Breite können unterschiedlich lange Bauelemente aufgenommen werden. Der Bandvorschub ist so ausgebildet, daß die Vorschublänge den unterschiedlichen Teilungen des Bandes angepaßt werden kann. Der Schieberhub muß so groß gehalten werden, daß auch die längsten Bauelemente sicher abgedeckt werden können.

Der Erfindung liegt die Aufgabe zugrunde, das Zuführmodul im Hinblick auf das Sichern und Freigeben der Bauelemente zu vereinfachen. Diese Aufgabe wird durch die Erfindung gemäß Anspruch 1 gelöst.

Die in der Vorschubrichtung orientierte maximale Länge der Bauelemente ist erheblich größer als die maximale Breite. Das transversal auslenkbare Verriegelungselement benötigt somit einen geringeren Hub, der zudem unabhängig von den Abmessungen des Bauelementes sein kann. Dadurch kann die Betätigungsmechanik des Verriegelungselementes erheblich einfacher ausgebildet werden. Insbesondere bei breiten Bauelementen ist es möglich, daß das Verriegelungselement schmaler ist als diese. Es ist daher von Vorteil, wenn das Verriegelungselement in der Sperrstellung die Bauelementemitte mit geringem Abstand überdeckt, um das Bauteil sicher am Aufstellen zu hindern.

Vorteilhafte Weiterbildungen der Erfindung sind in den Ansprüchen 2 bis 4 gekennzeichnet:

Der Finger nach Anspruch 2 kann z.B. an seinem anderen Ende schwenkbar gelagert sein und durch eine Torsionsfeder in seiner Sperrstellung gehalten werden. Ein besonderer Vorteil besteht darin, daß das Verriegelungselement vollständig oberhalb des Bauteilebandes angeordnet und gelagert werden kann. Die seitliche Auslenkung des Fingers kann z.B. mittels eines einfachen Stößels von geringem Hub erfolgen.

Durch die Weiterbildung nach Anspruch 3 wird die Verriegelung noch mehr vereinfacht. Die hochkant über dem Bauteileband stehende Biegefeder ist seitlich leicht auslenkbar, aber in der zur Bandebene senkrechten Richtung hinreichend steif, um die geringen Aufstellkräfte der Bauelemente aufzunehmen. Das Verriegelungselement ist lediglich an seinem unfreien Ende am Zuführmodul verankert und benötigt keinerlei zusätzlich Abstützung oder Führung.

Durch die Weiterbildung nach Anspruch 4 sind die Antriebsund Sperrfunktionen des Verriegelungselementes in einem Bauteil vereinigt, das durch bloßes Anlegen einer elektrischen Spannung betätigt werden kann. Derartige Biegewandler sind in geeigneten Abmessungen kostengünstig erwerbbar. Der mechanische Aufwand beschränkt sich auf die feste Einspannstelle am Zuführmodul sowie auf das Anschließen einer elektrischen Leitung an die im Zuführmodul vorhandenen elektrischen Potentiale.

Im folgenden wird die Erfindung anhand eines in der Zeichnung dargestellten Ausführungsbeispieles näher erläutert.
- Figur 1: zeigt eine schematisierte Seitenansicht eines Zuführmoduls für elektrische Bauelemente zu einem Bestückautomaten,
- Figur 2: eine Draufsicht auf das Zuführmodul nach Figur 1 mit einem in der Sperrstellung befindlichen Verriegelungselement,
- Figur 3: das Zuführmodul nach Figur 2 in einer Öffnungsstellung des Verriegelungselementes.

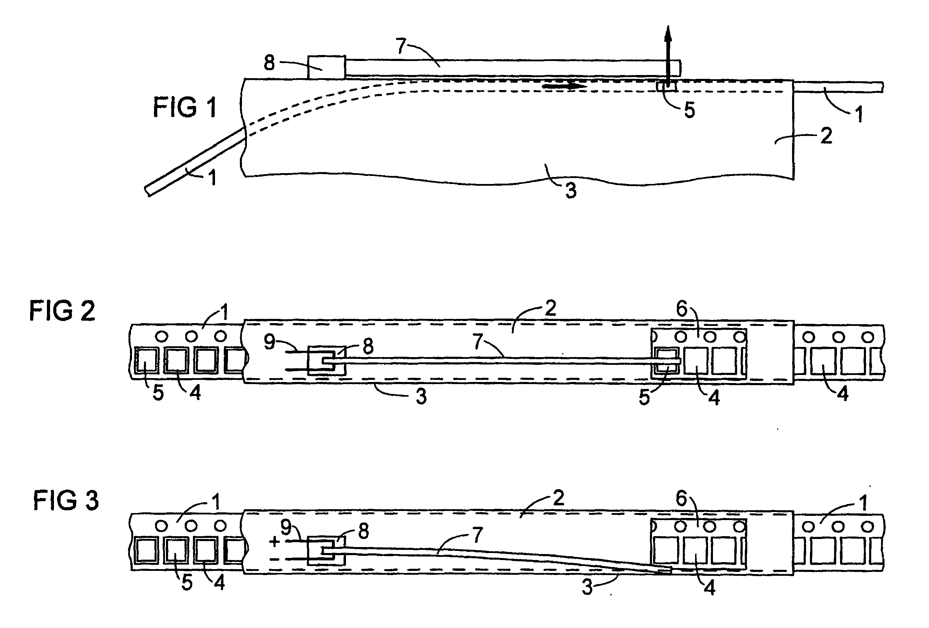

Nach den Figuren 1 und 2 wird ein von einer Spule abgewickeltes Bauteileband 1 durch ein Zuführmodul 2 entsprechend den gestrichelten Linien mit geringem Abstand zu einer Außenseite 3 des Zuführmoduls 2 hindurchgeführt, wobei sich die Außenseite 3 in der Längsrichtung des Bauteilebandes 1 und senkrecht zu dessen Ebene erstreckt.

Das Bauteileband 1 weist in seiner Längsrichtung eng aneinandergereihte Taschen 4 zur Aufnahme von zuzuführenden elektrischen Bauelementen 5 auf. Das Bauteileband 1 wird entsprechend dem Teilungsabstand der Taschen 4 mittels eines nicht dargestellten Antriebes schrittweise durch das Zuführmodul 2 hindurchgezogen. Die Bauelemente 5 gelangen dabei unter ein nach oben offenes Fenster 6 des Zuführmoduls 1, wo sie durch eine nicht dargestellte Saugpipette eines Bestückkopfes zum Bestücken von Leiterplatten ergriffen und entsprechend dem zum Bauteileband 1 senkrechten Pfeil in Figur 1 herausgehoben werden können. Die Vorschubrichtung des Bauteilebandes 1 ist durch den waagerechten Pfeil angedeutet.

Über der Zuführstrecke des Bauteilebandes 1 ist ein Verriegelungselement 7 in der Art einer einseitig eingespannten Blattfeder angeordnet, die sich in der Mittelebene der Bauelemente 5 entlang der Zuführstrecke erstreckt und mit ihrer Materialebene senkrecht zur Ebene des Bauteilebandes 1 steht. Das freie Ende des Verriegelungselementes 7 ragt aus der Zuführrichtung soweit in das Fenster 6 hinein, daß es das darin befindliche entnahmebereite Bauelement 5 mittig übergreift. Dadurch wird beim ruckartigen Vorschieben des Bauteilebandes 1 verhindert, daß dieses freiliegende Bauelement 5 seine Abhollage verändert. Das Verriegelungselement 7 ist als piezoelektrischer Biegewandler ausgebildet, dessen anderes Ende in einem Festlager 8 des Zuführmodul 2 eingespannt ist. Im nicht aktivierten Zustand ist das Verriegelungselement 7 geradlinig gestreckt.

Im Bereich des Festlagers 8 sind an das piezokeramische Verriegelungselement 7 elektrische Leitungen 9 angeschlossen. Beim Anlegen einer Spannung wird das Verriegelungselement 7 gemäß Figur 3 soweit seitlich ausgelenkt, daß es das entnahmebereite Bauelement 5 freigibt, das nun entsprechend dem senkrechten Pfeil in Figur 1 aus der Tasche 4 des Bauteilebandes 1 herausgehoben wird. Danach wird die angelegte Spannung abgeschaltet, worauf das Verriegelungselement 7 in seiner Ausgangslage zurückfedert und das nachfolgende Bauelement überragt.

## Patentansprüche

1. Zuführmodul (2) für elektrische Bauelemente (5) zu einem Bestückautomaten,
wobei die Bauelemente (5) im Zuführmodul in eine Abholposition verschiebbar sind, aus der sie von einem Bestückkopf des Bestückautomaten entnehmbar und auf einen zu bestückenden Bauelementeträger aufsetzbar sind,
wobei eine Entnahmeseite der Abholpostion mittels eines verstellbaren Verriegelungselementes (7) versperrbar ist, daß in einer Sperrstellung das zugeführte Bauelement (5) zumindest teilweise überdeckt und daß in einer Entnahmestellung das Bauelement (5) freigibt,
**dadurch gekennzeichnet,**
**daß** Verriegelungselement (7) als sich in die Vorschubrichtung erstreckender Streifen ausgebildet ist, dessen Breite geringer ist als der seitliche Abstand zwischen dem Bauelement (5) und einer benachbarten, sich in der Vorschubrichtung erstreckenden und zur Vorschubebene senkrechten Außenseite (3) des Zuführmoduls (2) und
**daß** das Verriegelungselement (7) transversal zur Vorschubrichtung in den Randbereich zwischen dem Bauelement (5) und der Außenseite (3) bewegbar ist.

2. Zuführmodul nach Anspruch 1,
**dadurch gekennzeichnet,**
**daß** das Verriegelungselement (7) als in der Vorschubrichtung ragender schmaler Finger ausgebildet ist, dessen freies Ende den Streifen bildet und in der Sperrstellung in den Entnahmebereich des Bauelementes (5) hineinragt und daß das freie Ende durch seitliche Auslenkung in den Randbereich hineinbewegbar ist.

3. Zuführmodul nach Anspruch 2,
**dadurch gekennzeichnet,**
**daß** der Finger (z.B. 7) als freiragende Biegefeder ausgebildet ist, die mit ihrem unfreien Ende an einem Festlager (8) des Zuführmoduls (2) verankert ist.

4. Zuführmodul nach Anspruch 3,
**dadurch gekennzeichnet,**
**daß** die Biegefeder als elektrisch betätigbarer, insbesondere piezokeramischer Biegewandler (z.B. 7) ausgebildet ist.

## Claims

1. Supply module (2) for feeding electrical components (5) to an automatic component-mounting machine,
in which case the components (5) can be displaced in the supply module into a collection position from which they can be removed by a component-mounting head of the automatic component-mounting machine and can be placed onto a component carrier to be populated,
in which case a removal side of the collection position can be blocked by means of an adjustable locking element (7), that covers the supplied component (5) at least partially in a blocking position and that releases the component (5) in a removal position,
**characterized**
**in that** the locking element (7) is designed as a strip extending in the advancing direction, the width of which strip is less than the lateral distance between the component (5) and an adjacent exterior side (3) of the supply module (2), said exterior side extending in the advancing direction and being perpendicular to the advancing plane, and
**in that** the locking element (7) can be moved transversally with respect to the advancing direction into the edge region between the component (5) and the exterior side (3).

2. Supply module according to Claim 1,
**characterized**
**in that** the locking element (7) is designed as a narrow finger projecting in the advancing direction, the free end of which finger forms the strip and projects into the removal region of the component (5) in the blocking position, and in that the free end can be moved into the edge region by lateral deflection.

3. Supply module according to Claim 2,
**characterized**
**in that** the finger (e.g. 7) is designed as a freely projecting bending spring which is anchored by its non-free end on a fixed bearing (8) of the supply module (2).

4. Supply module according to Claim 3,
**characterized**
**in that** the bending spring is designed as an electrically actuable, in particular piezoceramic, bending transducer (e.g. 7).

## Revendications

1. Module d'acheminement (2) de composants électriques (5) vers un automate de mise en place,
dans lequel les composants (5) peuvent être déplacés dans le module d'acheminement jusque dans une position d'enlèvement de laquelle ils peuvent être enlevés par une tête de mise en place de l'automate de mise en place et être placés sur un support de composants à équiper,
dans lequel un côté d'enlèvement de la position d'enlèvement peut être bloqué au moyen d'un élément de verrouillage (7) ajustable qui, dans une position de blocage, recouvre au moins partiellement le composant (5) acheminé et libère le composant (5) dans une position d'enlèvement,
**caractérisé en ce que**
l'élément de verrouillage (7) est configuré comme bande s'étendant dans la direction d'avancement, dont la largeur est inférieure à la distance latérale entre le composant (5) et un côté extérieur (3) du module d'acheminement (2) voisin, s'étendant dans la direction d'avancement et perpendiculaire au plan d'avancement, et **en ce que**
l'élément de verrouillage (7) peut être déplacé transversalement par rapport à la direction d'avancement dans la zone de bordure située entre le composant (5) et les côtés extérieurs (3).

2. Module d'acheminement selon la revendication 1, **caractérisé en ce que** l'élément de verrouillage (7) est configuré comme doigt étroit débordant dans la direction d'avancement dont l'extrémité libre forme la bande et qui pénètre dans la zone d'enlèvement du composant (5) dans la position de blocage, et **en ce que** l'extrémité libre peut être déplacée vers l'intérieur dans la zone de bordure par déviation latérale.

3. Module d'acheminement selon la revendication 2, **caractérisé en ce que** le doigt (par exemple 7) est configuré comme ressort de flexion débordant librement qui est ancré par son extrémité non libre à un support fixe (8) du module d'acheminement (2).

4. Module d'acheminement selon la revendication 3, **caractérisé en ce que** le ressort de flexion est configuré comme convertisseur de flexion (par exemple 7) actionnable électriquement, et en particulier piezocéramique.
